(19) Europäisches Patentamt
European Patent Office
Office européen des brevets

(11) **EP 4 057 271 B1**

(12) **FASCICULE DE BREVET EUROPEEN**

(45) Date de publication et mention de la délivrance du brevet:
**26.07.2023 Bulletin 2023/30**

(21) Numéro de dépôt: **22158019.4**

(22) Date de dépôt: **22.02.2022**

(51) Classification Internationale des Brevets (IPC):
**G09G 5/36** *(2006.01)*  **G06F 3/14** *(2006.01)*
**G01R 31/00** *(2006.01)*  **G06F 11/00** *(2006.01)*

(52) Classification Coopérative des Brevets (CPC):
**G09G 5/36; G06F 3/1462;** G01R 31/008;
G09G 2330/10; G09G 2330/12; G09G 2380/12

(54) **PROCÉDÉ DE TEST D'UN DISPOSITIF ÉLECTROPORTATIF**

VERFAHREN ZUM PRÜFEN EINES TRAGBAREN ELEKTRONISCHEN GERÄTS

METHOD FOR TESTING A PORTABLE ELECTRONIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.03.2021 FR 2102321**

(43) Date de publication de la demande:
**14.09.2022 Bulletin 2022/37**

(73) Titulaire: **Airbus Helicopters**
**13725 Marignane Cedex (FR)**

(72) Inventeurs:
• **BAILLY, Stéphane**
**13480 CABRIES (FR)**
• **HERROU, Anthony**
**26790 ROCHEGUDE (FR)**
• **CARLE, Cyrille**
**83150 BANDOL (FR)**

(74) Mandataire: **GPI Brevets**
**1330, rue Guillibert de la Lauzière**
**EuroParc de Pichaury**
**Bât B2**
**13856 Aix en Provence Cedex 3 (FR)**

(56) Documents cités:
**US-A1- 2007 233 765   US-A1- 2009 243 893**
**US-A1- 2018 329 780   US-A1- 2019 196 926**

## Description

La présente invention concerne un procédé de test d'un dispositif électroportatif tel un téléphone intelligent dénommé usuellement « smartphone » en langue anglaise, une tablette tactile ou encore un ordinateur. Un tel dispositif électroportatif peut notamment comporter un organe d'acquisition, une unité de traitement, une unité de stockage et un écran d'affichage.

Un tel dispositif électroportatif peut également avantageusement comporter une source d'énergie électrique autonome telle une batterie ou des accumulateurs rechargeables permettant de stocker de l'énergie électrique. La source d'énergie électrique peut alimenter en énergie électrique l'unité de traitement, l'unité de stockage et l'écran d'affichage.

Plus particulièrement, l'invention se rapporte à un procédé de test adapté pour sécuriser l'élaboration et l'affichage de données, comme par exemple un manuel de vol ou des tables de performance d'un aéronef tel un avion ou un giravion, à partir d'un dispositif électroportatif usuel. Un tel procédé de test peut ainsi être mis en oeuvre en tout ou partie au sol sur une plateforme sol, en tout ou partie au sol dans l'aéronef lors d'une phase de préparation d'une mission de l'aéronef ou encore en tout ou partie en vol pendant une phase de vol de l'aéronef.

Pour des raisons de sécurité, il est en effet important d'afficher des informations exactes. En cas de pertes d'intégrité, un dispositif électroportatif peut afficher des informations fausses mais non aberrantes difficiles à détecter, peut figer des informations sur un écran ou encore peut afficher des données avec retard, ce qui peut s'avérer problématique pour le pilotage d'un aéronef.

De façon connue, et tel que décrit dans le document EP 3 495 775, un procédé de test d'un dispositif électroportatif peut utiliser un support d'accueil permettant de recevoir et de maintenir en position le dispositif électroportatif par rapport à une planche de bord d'un aéronef.

En outre, le support d'accueil comporte une caméra permettant de filmer les images affichée sur l'écran du dispositif électroportatif puis de transmettre les images acquises par la caméra à un système de contrôle embarqué dans l'aéronef. Ce système de contrôle est apte à comparer les images acquises par la caméra avec des images attendues pour identifier par exemple une erreur d'affichage et plus particulièrement une perte d'intégrité dispositif électroportatif.

Cependant, un tel procédé nécessite d'équiper l'aéronef avec des organes supplémentaires dédiés, tels que notamment un support d'accueil comportant une caméra et un système de contrôle externe embarqué dans l'aéronef pour analyser les images acquises par la caméra.

On connaît également des procédés alternatifs tels que décrits dans les documents US2019/196926A1, US2018/329780A1, US2007/0233765A1 et US2009/243893A1.

Le document US2019/196926A1 décrit une unité de traitement graphique d'un sous-système GPU d'un dispositif informatique fonctionnant dans un premier mode de rendu pour traiter des données graphiques afin de produire une première image. Le GPU fonctionne dans un second mode de rendu pour traiter les données graphiques afin de produire une seconde image. Le dispositif informatique détecte si un défaut s'est produit dans le sous-système GPU sur la base au moins en partie de la comparaison de la première image avec la seconde image.Ce document décrit également un procédé de test d'un dispositif électroportatif comportant une unité de traitement, une première unité de stockage et un écran d'affichage.

Le document US2018/329780A1 se rapporte à un système de traitement à haute intégrité des données (« HDIPS ») qui comprend un premier dispositif de traitement et un dispositif de traitement à triple vote (« TVP ») en communication de signal avec le premier dispositif de traitement. Le premier dispositif de traitement a une résistance élevée aux rayonnements et comprend un processeur, une mémoire cache et un support lisible par ordinateur (« CRM »). Le CRM est codé avec des instructions exécutables par ordinateur pour amener le processeur à exécuter un premier contrôle d'intégrité périodique sur le premier dispositif de traitement produisant un premier résultat d'intégrité, qui est transmis au dispositif TVP. Le dispositif TVP comprend un micrologiciel sur lequel sont codées des instructions machine pour, simultanément avec le premier contrôle d'intégrité périodique, amener le dispositif TVP à exécuter un deuxième contrôle d'intégrité produisant un deuxième résultat d'intégrité, comparer le premier résultat d'intégrité avec le deuxième résultat d'intégrité et réinitialiser l'alimentation du premier dispositif de traitement si le premier résultat d'intégrité ne correspond pas au deuxième résultat d'intégrité.

Le document US2007/0233765A1 concerne quant à lui un système et un procédé de génération de test pour une vérification de niveau système à l'aide d'algorithmes parallèles. Ce procédé génère des motifs de test pour des tests au niveau du système en exploitant l'évolutivité d'algorithmes parallèles tout en permettant la coloration de l'ensemble de données et la vérification des résultats attendus. Sur la base des caractéristiques du système testé, un algorithme parallèle itératif est sélectionné parmi une pluralité d'algorithmes parallèles possibles. L'algorithme parallèle sélectionné est ensuite séparé en instructions de programme séparées pour exécution par une pluralité de processeurs. Une version en série de l'algorithme sélectionné est exécutée pour générer un ensemble de résultats attendus. La version parallèle conçue de l'algorithme sélectionné est ensuite exécutée pour générer un ensemble de données de résultats de test qui est comparé à l'ensemble de résultats attendus. Si les deux ensembles de données correspondent, il est déterminé que le système fonctionne correctement.

Le document US 2009/243893A1 se rapporte au domaine de la sûreté de fonctionnement des systèmes de visualisation et plus particulièrement celui des systèmes de cockpit embarqués sur aéronefs. Il décrit un procédé de codage des pixels d'une image numérique couleur comportant des symboles critiques représentés par des pixels critiques, chaque pixel coloré étant codé sur trois composantes numériques comportant chacune le même nombre de bits. Les composantes des pixels critiques comportent d'une part une information de couleur et d'autre part un marqueur encore appelé « tag » codé sur au moins un bit. En outre, un tel marqueur est destiné à être exploité par des fonctions de génération et de prédiction des symboles critiques.

La présente invention a alors pour objet de proposer un procédé de test alternatif d'un dispositif électroportatif permettant de s'affranchir des limitations mentionnées ci-dessus. Un tel procédé a notamment pour but de détecter l'affichage de données erronées difficilement détectables par l'utilisateur sans avoir recours à un support d'accueil muni d'une caméra ni d'un système de contrôle externe.

L'invention se rapporte donc à un procédé de test d'un dispositif électroportatif, le dispositif électroportatif comportant un organe d'acquisition, une unité de traitement comportant une mémoire cache, une première unité de stockage et un écran d'affichage.

Selon l'invention, un tel procédé est remarquable en ce qu'il comporte les étapes suivantes :

- acquisition d'un ensemble de paramètres X comportant au moins un paramètre x via l'organe d'acquisition,
- mémorisation de l'ensemble de paramètres X dans une première zone de la première unité de stockage,
- mémorisation de l'ensemble de paramètres X dans une seconde zone de la première unité de stockage, la seconde zone étant distincte de la première zone,
- génération d'au moins une première image représentative d'un premier ensemble de résultats Y1 comportant au moins un premier résultat y1, le premier ensemble de résultats Y1 étant généré par application d'un premier traitement par l'unité de traitement à partir de l'ensemble de paramètres X mémorisé dans la première zone de la première unité de stockage,
- premier affichage de la au moins une première image sur l'écran d'affichage pendant une première période de temps prédéterminée,
- premier effacement de premiers résultats intermédiaires correspondant à des étapes de calcul opérées lors du premier traitement, les premiers résultats intermédiaires étant effacés de la mémoire cache de l'unité de traitement,
- génération d'au moins une seconde image représentative d'un deuxième ensemble de résultats Y2 comportant au moins un deuxième résultat y2, le deuxième ensemble de résultats Y2 étant généré par application d'un deuxième traitement par l'unité de traitement à partir de l'ensemble de paramètres X mémorisé dans la seconde zone de la première unité de stockage, le premier ensemble de résultats Y1 et le deuxième ensemble de résultats Y2 étant égaux sauf en cas de perte d'intégrité du dispositif électroportatif et
- second affichage de la au moins une seconde image sur l'écran d'affichage pendant une seconde période de temps prédéterminée.

Un tel ensemble de paramètres X peut par exemple comporter au moins un paramètre x choisi parmi les paramètres liés à la charge embarquée dans l'aéronef, les paramètres liés aux performances de vol de l'aéronef, les paramètres liés à la mission que doit effectuer l'aéronef, les paramètres liés aux conditions météorologiques ou encore les paramètres liés à la visibilité ou aux conditions de vol de l'aéronef.

Comme précédemment indiqué, un tel procédé est configuré pour permettre à un utilisateur du dispositif électroportatif de détecter une perte d'intégrité du dispositif électroportatif préalablement à son utilisation ou bien encore lors de son utilisation en vol. En outre, une telle perte d'intégrité peut concerner l'unité de traitement comportant une mémoire cache mais également la première unité de stockage formée par exemple par une mémoire morte de type ROM selon l'acronyme de l'expression en langue anglaise « *Read-Only Memory* » ou une mémoire vive de type RAM selon l'acronyme de l'expression en langue anglaise « *Random Access Memory* ». La perte d'intégrité peut également concerner un écran d'affichage ou encore un organe de saisie.

Ainsi, un tel procédé de test peut être mis en oeuvre constamment lors d'une phase de vol de l'aéronef et donc d'une utilisation du dispositif électroportatif. Les premier et deuxième ensembles de résultats Y1, Y2 peuvent donc être porteurs d'une information utile au pilotage de l'aéronef telle que par exemple une vitesse de déplacement maximale, un taux de montée maximum, un plafond, une masse maximale au décollage ...

La détection d'une perte d'intégrité du dispositif électroportatif peut par exemple être opérée visuellement par l'utilisateur s'il constate des différences entre les premières images et les secondes images. De telles différences ont alors pour effet de générer un affichage flou ou clignotant de tout ou partie des images affichées sur l'écran d'affichage. Un tel affichage flou ou un clignotement des images est alors aisément perceptible par un utilisateur du dispositif électroportatif.

En outre, une telle détection d'une perte d'intégrité du dispositif électroportatif peut également être réalisée automatiquement par une analyse des différences entre les premier et deuxième ensembles de résultats Y1, Y2 et/ou entre les premières images et les secondes images. Une telle analyse peut avantageusement être réalisée directement par l'unité de traitement du dispositif électroportatif.

Selon un premier mode de réalisation de l'invention, le procédé peut comporter une mémorisation du premier ensemble de résultats Y1 dans une première zone d'une seconde unité de stockage et une mémorisation du deuxième ensemble de résultats Y2 dans une seconde zone de la seconde unité de stockage.

Dans ce cas, les étapes de génération d'au moins une première image représentative d'un premier ensemble de résultats Y1 et de génération d'au moins une seconde image représentative d'un deuxième ensemble de résultats Y2 peuvent être réalisées respectivement une seule fois. Ces étapes de génération d'au moins une première image et d'au moins une seconde image peuvent être réalisées l'une après l'autre, de manière enchaînée par un même microprocesseur de l'unité de traitement. L'unité de traitement peut alternativement comporter plusieurs microprocesseurs ou un microprocesseur de type multi-coeur et réaliser alors simultanément de telles étapes de génération d'au moins une première image et d'au moins une seconde image.

Cependant, les étapes de premier affichage de ladite au moins une première image et de second affichage de la au moins une seconde image peuvent être quant à elles répéter plusieurs fois en alternance. Cette répétition selon une séquence de plusieurs boucles des étapes d'affichage permet ainsi éventuellement de provoquer un clignotement des images si des différences sont présentes entre les première et seconde images.

Selon un premier exemple du premier mode de réalisation, la première unité de stockage peut être confondue avec la seconde unité de stockage et être formée par une mémoire vive adressable pour pouvoir rappeler les premier et second ensembles de résultats Y1 et Y2.

Selon un second exemple de réalisation du premier mode de réalisation, la première unité de stockage peut être distincte de la seconde unité de stockage. Par exemple, l'ensemble de paramètres X peut être stocké dans une mémoire morte de type ROM du dispositif électroportatif. Les premier et second ensembles de résultats Y1 et Y2 peuvent quant à eux être par exemple stockés dans une mémoire morte de type ROM externe telle une carte mémoire amovible.

Selon un troisième exemple de réalisation du premier mode de réalisation, la première unité de stockage peut être partiellement confondue avec la seconde unité de stockage. Par exemple, la première zone de la première unité de stockage peut être confondue avec la seconde zone de la seconde unité de stockage. De même, la seconde zone de la première unité de stockage peut être confondue avec la première zone de la seconde unité de stockage.

Ainsi, la première zone de la première unité de stockage et la seconde zone de la seconde unité de stockage peuvent ainsi être formées par la mémoire morte du dispositif électroportatif type ROM. La seconde zone de la première unité de stockage et la première zone de la seconde unité de stockage peuvent être quant elles formées par une mémoire morte de type ROM externe.

Alternativement et selon un second mode de réalisation de l'invention, le procédé peut comporter un second effacement d'étapes de calcul opérées lors du second traitement, les étapes de calcul étant effacées de la mémoire cache de l'unité de traitement.

En d'autres termes, le premier ensemble de résultats Y1 et le deuxième ensemble de résultats Y2 ne sont dans ce cas plus nécessairement mémorisés.

Une séquence peut alors répéter plusieurs fois en boucle les étapes de génération de la ou des premières images, de premier affichage de la ou des premières images, de premier effacement des premiers résultats intermédiaires, de génération de la ou des secondes images, de second affichage de ou des secondes images et de second effacement des seconds résultats intermédiaires.

En outre, le procédé de test conforme à l'invention peut également comporter une première sous étape de vérification consistant à vérifier qu'au moins un paramètre x de l'ensemble de paramètres X est compris dans une première plage de valeurs prédéterminée.

En outre, lorsque le au moins un paramètre x de l'ensemble de paramètres X n'est pas compris dans la première plage de valeurs prédéterminée, un affichage de ce paramètre x peut l'indiquer sur l'écran d'affichage. Par exemple, le fond d'affichage peut changer de couleur sur l'image affichée et aucune validation du paramètre x n'est possible.

De même, le procédé de test conforme à l'invention peut comporter une deuxième sous étape de vérification consistant à vérifier que le au moins un premier résultat y1 du premier ensemble de résultats Y1 est compris dans une deuxième plage de valeurs prédéterminée.

Par analogie, le procédé de test conforme à l'invention peut comporter une troisième sous étape de vérification consistant à vérifier qu'au moins un deuxième résultat y2 du deuxième ensemble des résultats Y2 est compris dans une troisième plage de valeurs prédéterminée.

Selon une possibilité, le premier traitement et le deuxième traitement peuvent être identiques.

Autrement dit, l'unité de traitement effectue le même traitement à un ou aux paramètres x de l'ensemble de paramètres X mémorisés respectivement d'une part dans la première zone de la première unité de stockage et d'autre part dans la seconde zone de la première unité de stockage.

Selon une autre alternative, le premier traitement et le deuxième traitement peuvent être équivalents, le premier traitement mettant en oeuvre des calculs opérés selon un premier ordre et le deuxième traitement mettant en oeuvre des calculs équivalents opérés selon un second ordre différent du premier ordre.

Dans ce cas, le deuxième traitement est donc différent du premier traitement mais doit néanmoins aboutir sensiblement au même résultat que celui obtenu à partir du premier traitement, hors cas de panne ou de perte d'intégrité du dispositif électroportatif. Des écarts minimes de calcul peuvent apparaitre, liés au traitement numérique et à la précision de calcul de l'unité de traitement. Le choix de l'ordre des calculs du deuxième traitement est tel que ces écarts minimes peuvent être éliminés par un simple arrondi des résultats, avec un nombre de chiffres significatifs tels qu'une précision suffisante est conservée pour l'usage final.

Par exemple, le premier traitement peut consister à effectuer le calcul suivant :

$$(x + l) * m*n = y1$$

où x, l, m, n sont des paramètres appartenant à l'ensemble de paramètres X et y1 un premier résultat appartenant au deuxième ensemble de résultats Y1.

Le deuxième traitement équivalent au premier traitement peut alors consister quant à lui à effectuer le calcul suivant :

$$n*m*(l + x) = y2$$

où x, l, m, n sont des paramètres appartenant à l'ensemble de paramètres X et y2 un deuxième résultat appartenant au deuxième ensemble de résultats Y2.

Selon un autre exemple de réalisation de l'invention compatible avec les précédents, la au moins une première image peut comporter un premier fond agencé en arrière plan et le premier ensemble de résultats Y1 rapporté en superposition sur le premier fond et la au moins une seconde image peut comporter un second fond agencé en arrière plan et le deuxième ensemble de résultats Y2 rapporté en superposition sur le second fond.

En outre, le premier fond et le second fond peuvent occuper tout ou partie des au moins une première et au moins une seconde image. Par ailleurs, lorsque le premier fond occupe seulement une première partie de la au moins une première image et le second fond occupe seulement une seconde partie de la au moins une seconde image, ces première et seconde parties peuvent être de mêmes dimensions et être formées par un même nombre de pixels de l'écran d'affichage.

De plus, les première et seconde parties peuvent être avantageusement agencées dans une même portion desdites au moins une première et au moins une seconde images. Dans ce cas, lorsque le premier et le second fond sont identiques, les différences constatées par l'utilisateur entre la au moins une première image et la au moins une seconde image peuvent consister en un clignotement du premier résultat et du deuxième résultat.

Par ailleurs selon un autre exemple de réalisation de l'invention compatible avec les précédents, le premier fond pouvant être affiché pendant la première période de temps prédéterminée, le au moins un premier résultat peut être affiché avec un premier retard pendant une première durée inférieure à la première période de temps prédéterminée.

Dans ce cas, l'affichage de la au moins une première image permet de réaliser un affichage dynamique du au moins un premier résultat. Un tel affichage dynamique du au moins un premier résultat permet ainsi à l'utilisateur de détecter visuellement un gel de la au moins une première image à l'écran d'affichage du dispositif électroportatif.

Selon un autre aspect compatible avec les précédents, la première période de temps prédéterminée peut être égale à la seconde période de temps prédéterminée.

Ainsi, la au moins une première image et la au moins une seconde image sont affichées pendant la même période de temps prédéterminée. Une telle période de temps prédéterminée peut par exemple être comprise entre 0,5 secondes et 5 secondes.

Selon une possibilité compatible avec les précédentes, le procédé peut comporter les étapes suivantes :

- génération d'un troisième ensemble de résultats Y3 comportant au moins un troisième résultat y3 par application d'un troisième traitement par l'unité de traitement à partir d'un ensemble test de paramètres X3 comportant au moins un paramètre de test x3 préalablement mémorisé,

- comparaison du troisième ensemble de résultats Y3 avec un ensemble de résultats attendus Z3 préalablement mémorisé,

- détection d'une perte d'intégrité du dispositif électroportatif lorsqu'une différence entre le troisième ensemble de résultats Y3 et l'ensemble de résultats attendus Z3 est différente de zéro, à la précision de calcul près.

Autrement dit, l'unité de traitement peut effectuer le calcul du troisième ensemble de résultats Y3 correspondant à un cas connu, puis le compare avec l'ensemble de résultats attendus Z3 avant de procéder au lancement d'une nouvelle séquence de calculs demandée par l'utilisateur du dispositif électroportatif.

Une telle comparaison du troisième ensemble de résultats Y3 avec un ensemble de résultats attendus Z3 permet ainsi de vérifier les capacités de calculs de l'unité de traitement.

En outre, l'ensemble test de paramètres X3 et l'ensemble de résultats attendus Z3 sont avantageusement mémorisés dans la première unité de stockage ou dans la seconde unité de stockage.

De manière alternative ou complémentaire, le procédé peut comporter les étapes suivantes :

- génération d'un quatrième ensemble de résultats Y4 comportant au moins un quatrième résultat y4 par application d'un quatrième traitement par l'unité de traitement à partir d'un autre ensemble de test X4 comportant au moins un autre paramètre de test x4 généré de manière aléatoire, le quatrième traitement étant différent du premier traitement et du deuxième traitement,

- comparaison du quatrième ensemble de résultats Y4 avec un autre ensemble de résultats attendus Z4 mémorisé,
- détection d'une perte d'intégrité du dispositif électroportatif lorsqu'une différence entre le quatrième ensemble de résultats Y4 et le autre ensemble de résultats attendus Z4 est différente de zéro.

Cette méthode permet avantageusement de forcer l'unité de traitement à recalculer, sans pouvoir s'appuyer sur des résultats intermédiaires ou finaux précédemment stockés en mémoire cache.

En outre, l'autre ensemble test de paramètres X4 et l'autre ensemble de résultats attendus Z4 sont avantageusement mémorisés dans la première unité de stockage ou éventuellement dans la seconde unité de stockage.

Par exemple, cet autre ensemble test de paramètres X4 peut comporter au moins un autre paramètre de test x4 sous la forme d'un nombre choisi aléatoirement entre 0 et 1 et l'étape de génération du quatrième ensemble de résultats Y4 peut consister à appliquer à ce nombre des opérations mathématiques simples telles que des additions, des soustractions, des multiplications, des divisions ou des opérations plus complexes.

D'autres calculs peuvent également appliquer au nombre choisi aléatoirement des fonctions mathématiques telles que par exemple des fonctions valeurs absolues, des fonctions puissances, des fonctions racines, des fonctions exponentielles, des fonctions logarithmiques ou encore des fonctions trigonométriques telles que par exemple sinus, cosinus ou tangente, ou dérivée et intégrale.

Enfin, cette étape de génération du quatrième ensemble de résultats Y4 peut mettre en oeuvre des opérateurs logiques tels que le signe égal « = », l'opérateur logique ET connu sous le signe « && » dans le langage de programmation C++ ou l'opérateur logique OU connu sous le signe « || » dans le langage de programmation C++.

Selon un exemple de réalisation particulier, l'étape de génération du quatrième ensemble de résultats Y4 peut consister à effectuer des opérations du type de l'opération suivante :

$$\frac{\sqrt{\left(x4 + \left(1 - \left((\sin x4)^2 + \frac{1+\cos(2*x4)}{2}\right)\right)\right)*x4}}{x4} = y4$$

Le quatrième résultat y4 est alors comparé avec l'autre résultat attendus z4 pour cette opération qui est égal à 1.

Si ce quatrième résultat y4 est différent de 1, à la précision de calcul près, alors toutes les sorties de l'unité de traitement sont rendues invalides et les données de l'écran d'affichage sont effacées et éventuellement un message d'alerte peut être affiché pour indiquer que le dispositif électroportatif n'est plus intègre et ne doit donc plus être utilisé par son utilisateur.

Eventuellement, un test complet de l'ensemble du dispositif électroportatif peut être lancé en parallèle de l'affichage du message d'alerte.

En outre, le procédé de test conforme à l'invention peut également comporter une étape de vérification supplémentaire consistant à vérifier que le au moins un paramètre de test x4 est compris dans une autre plage de valeurs prédéterminée.

En pratique, le procédé peut comporter les étapes suivantes :

- affichage d'au moins une image de référence mémorisée, la au moins une image de référence permettant d'activer tous les pixels constituant l'écran d'affichage,
- détection d'un défaut d'affichage d'au moins un pixel de l'écran d'affichage.

Une telle succession d'étapes du procédé de test permet ainsi à un utilisateur du dispositif électroportatif de réaliser par exemple une détection visuelle d'un ou de plusieurs pixels ne fonctionnant plus sur l'écran d'affichage.

En outre, une telle détection de pixels dits « morts » peut également être partiellement réalisée automatiquement par une analyse de l'affichage de la ou des images de référence. Une telle analyse peut par exemple être réalisée directement par l'unité de traitement du dispositif électroportatif.

En outre, la ou les images de référence sont avantageusement mémorisées dans la première unité de stockage ou éventuellement dans la seconde unité de stockage.

Avantageusement, l'étape d'affichage de la au moins une image de référence et l'étape de détection d'un défaut d'affichage peuvent être opérées préalablement à l'étape d'acquisition de l'ensemble de paramètres X.

Ces étapes d'affichage de la au moins une image de référence et de détection d'un défaut d'affichage peuvent ainsi par exemple constituer des étapes d'initialisation du procédé de test.

Par ailleurs, le procédé peut comporter une étape de transmission d'un ordre de commande de l'organe d'acquisition vers l'unité de traitement, cet ordre de commande étant porteur d'un appel de l'étape d'affichage de la au moins une image de référence.

Dans ce cas, les étapes d'affichage de la au moins une image de référence et de détection d'un défaut d'affichage peuvent également être réalisées à tout moment à la demande de l'utilisateur du dispositif électroportatif.

En pratique, l'étape d'acquisition peut comporter une saisie d'au moins un paramètre x de l'ensemble de paramètres X avec un dispositif de saisie manuelle de l'organe d'acquisition, le dispositif de saisie manuelle étant choisi parmi le groupe comportant les boutons de commande, les claviers, les molettes, les désignateurs, les « souris » et les dalles tactiles.

L'utilisateur peut ainsi actionner manuellement l'organe d'acquisition pour générer l'ordre de commande qui peut alors être transmis à l'unité de traitement.

En outre une fois que l'ensemble de paramètres X est saisi par l'utilisateur, ou de manière alternative à chaque saisie d'un paramètre x de l'ensemble de paramètres X, le ou les paramètres x peuvent être affichés sur l'écran d'affichage du dispositif électroportatif pour que l'utilisateur puisse s'assurer que les paramètres X mémorisés sont bien ceux qui a été saisis par l'utilisateur. Si l'utilisateur constate une erreur à l'affichage des paramètres de X, l'utilisateur peut alors actionner une commande permettant de générer un ordre de commande pour lancer une étape d'initialisation du procédé de test et/ou l'utilisateur peut éventuellement de choisir de ne pas utiliser le dispositif électroportatif dont la perte d'intégrité a été identifiée. L'utilisateur peut ainsi choisir d'utiliser un autre dispositif électroportatif. En effet, un aéronef peut avantageusement embarquer à son bord au moins deux dispositifs électroportatifs.

Selon un autre mode de réalisation alternatif ou complémentaire, l'étape d'acquisition peut comporter une réception d'un signal électromagnétique porteur du au moins un paramètre x de l'ensemble de paramètres X, l'organe d'acquisition comportant une carte de communication sans fil apte à recevoir le signal électromagnétique par un protocole de communication sans fil.

Un tel protocole de communication sans fil peut par exemple être choisi parmi les protocoles de téléphonie mobile, les protocoles connus sous les dénominations Wi-Fi ou encore Bluetooth.

Dans ce cas, le procédé de test du dispositif électroportatif peut être déclenché à distance automatiquement par un système avionique de l'aéronef ou encore par une station sol avec laquelle le dispositif électroportatif est apte à communiquer par une liaison non filaire.

Avantageusement, la première étape d'effacement peut comporter une pluralité de calculs générant une pluralité de résultats stockés dans la mémoire cache de l'unité de traitement pour forcer un remplacement des résultats intermédiaires de la mémoire cache de l'unité de traitement.

Cette pluralité de calculs permet ainsi de réaliser un changement de contexte et autrement dit une purge de la mémoire cache de l'unité de traitement.

De cette manière, les premières étapes d'effacement et les éventuelles-secondes étapes d'effacement peuvent être réalisées simplement sans nécessiter un adressage des données stockées dans la mémoire cache de l'unité de traitement.

L'invention et ses avantages apparaîtront avec plus de détails dans le cadre de la description qui suit avec des exemples donnés à titre illustratif en référence aux figures annexées qui représentent :

la figure 1, une vue de face d'un dispositif électroportatif destiné à être utilisé à bord d'un aéronef,

la figure 2, un premier logigramme illustrant un premier exemple de réalisation d'un procédé de test d'un dispositif électroportatif conformément à l'invention,

la figure 3, un deuxième logigramme illustrant un deuxième exemple de réalisation d'un procédé de test d'un dispositif électroportatif, conformément à l'invention, et

la figure 4, un troisième logigramme illustrant un troisième exemple de réalisation d'un procédé de test d'un dispositif électroportatif, conformément à l'invention.

Les éléments présents dans plusieurs figures distinctes sont affectés d'une seule et même référence.

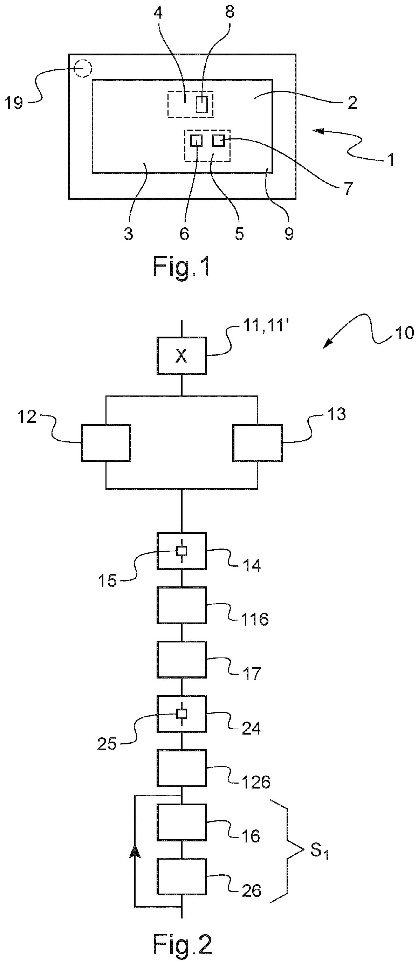

Tel que représenté à la figure 1, un dispositif électroportatif 1 peut se présenter sous la forme d'une tablette tactile, d'un téléphone tel un smartphone, ou encore d'un ordinateur. Le dispositif électroportatif 1 comporte ainsi un organe d'acquisition 2 comportant par exemple un dispositif de saisie manuelle 9.

Un tel dispositif de saisie manuelle 9 peut notamment comporter des boutons, un clavier, une molette ou une dalle tactile permettant à un utilisateur de saisir manuellement et d'acquérir des données ou des valeurs de paramètres.

Alternativement ou de façon complémentaire, l'organe d'acquisition 2 peut comporter une carte de communication sans fil 19 apte à recevoir un signal électromagnétique par un protocole de communication sans fil.

De plus, le dispositif électroportatif 1 comporte une unité de traitement 4, une première unité de stockage 5 et un écran d'affichage 3.

L'unité de traitement 4 peut comprendre par exemple au moins un processeur et au moins une mémoire, au moins un circuit intégré, au moins un système programmable, au moins un circuit logique, ces exemples ne limitant pas la portée donnée à l'expression « unité de traitement ». Le terme processeur peut désigner aussi bien une unité centrale de traitement connue sous l'acronyme CPU, une unité graphique de traitement GPU, une unité digitale connue sous l'acronyme DSP, un microcontrôleur, un système connu sous l'acronyme SoC désignant l'expression en langue anglaise « System on Chip » regroupant plusieurs de ces fonctions... Une telle unité de traitement 4 comporte en outre une mémoire cache 8 interne.

Par ailleurs, la première unité de stockage 5, pouvant être séparée de l'unité de traitement 4 ou regroupée avec cette unité de traitement 4 sur un même circuit intégré, comporte une première zone 6 de stockage et une seconde zone 7 de stockage, la seconde zone 7 étant distincte de la première zone 6. Autrement dit, l'adresse de la première zone 6 est différente, et éventuellement adjacente, de l'adresse de la seconde zone 7.

Tel que représenté à la figure 2, un premier exemple de réalisation d'un procédé 10 de test d'un dispositif électroportatif 1 comporte une succession de plusieurs étapes.

Ainsi, le procédé 10 comporte une étape d'acquisition 11, 11' d'une valeur d'au moins un paramètre x constituant un ensemble de paramètres X via l'organe d'acquisition 2 du dispositif électroportatif 1.

En pratique, l'étape d'acquisition 11 de l'ensemble de paramètres X peut être opérée manuellement par un utilisateur du dispositif électroportatif 1 lorsque l'organe d'acquisition 2 comporte un dispositif de saisie manuelle 9.

Alternativement ou de façon complémentaire, l'étape d'acquisition 11' de l'ensemble de paramètres X peut être opérée par une réception d'un signal électromagnétique lorsque l'organe d'acquisition 2 comporte une carte de communication sans fil 19 pour recevoir le signal électromagnétique par un protocole de communication sans fil.

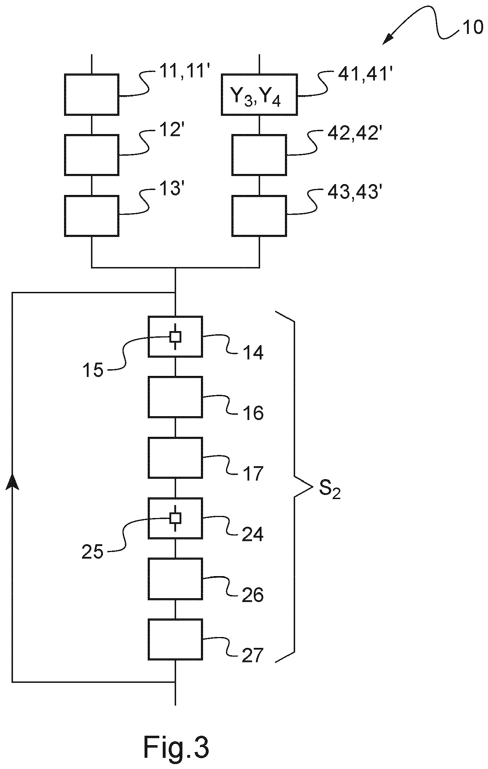

Le procédé 10 comporte ensuite une étape de mémorisation 12 de l'ensemble de paramètres X dans la première zone 6 de la première unité de stockage 5 et par exemple parallèlement, ou simultanément, une étape de mémorisation 13 du même ensemble de paramètres X dans la seconde zone 7 de la première unité de stockage 5. Selon un autre exemple de réalisation du procédé 10 tel que représenté à la figure 3, l'étape de mémorisation 12' et l'étape de mémorisation 13' peuvent également être mises en oeuvre successivement l'une après l'autre. Cependant quel que soit l'exemple de réalisation du procédé de test, les deux étapes de mémorisation peuvent être mises en oeuvre l'une après l'autre ou encore simultanément.

Avantageusement, le ou les paramètres x mémorisés dans au moins une des zones 6 et 7 de la première unité de stockage peuvent être affichés sur l'écran d'affichage 3 permettant à l'utilisateur de s'assurer que ce qui est mémorisé est conforme à la saisie effectuée sur le dispositif de saisie manuelle 9.

Quelle que soit la réalisation et la manière de paramétrer la valeur du ou des paramètres x de l'ensemble de paramètres X, le procédé 10 peut comporter une séquence S1, S2 de plusieurs boucles consistant à répéter successivement plusieurs étapes.

Le procédé 10 comporte alors une étape de génération 14 d'au moins une première image représentative d'au moins un premier ensemble de résultats Y1 comportant au moins un premier résultat y1, le premier ensemble de résultats Y1 étant généré par application d'un premier traitement par l'unité de traitement 4 à partir du au moins un paramètre x de l'ensemble de paramètres X mémorisé dans la première zone 6 de la première unité de stockage 5. Cette étape de génération 14 d'au moins une première image peut éventuellement comporter une première sous étape de duplication 15 du ou des paramètres x de l'ensemble de paramètres X et éventuellement des résultats intermédiaires dans la mémoire cache 8 de l'unité de traitement 4.

Le procédé 10 comporte ensuite une mémorisation 116 du premier ensemble de résultats Y1 dans une première zone d'une seconde unité de stockage qui peut être éventuellement en tout ou partie confondue avec la première unité de stockage 5.

Le procédé 10 procède alors ensuite à une étape d'effacement 17 de premiers résultats intermédiaires correspondant à des étapes de calcul opérées lors du premier traitement. Ainsi, une telle étape d'effacement 17 permet d'opérer un changement de contexte de la mémoire cache 8 de l'unité de traitement 4.

En pratique, cette première étape d'effacement 17 peut être réalisée au moyen d'une pluralité de calculs générant une pluralité de résultats stockés dans la mémoire cache 8 de l'unité de traitement 4 pour remplacer l'ensemble de paramètres X et éventuellement des résultats intermédiaires.

Le procédé 10 comporte alors une étape de génération 24 d'au moins une seconde image représentative d'au moins un deuxième ensemble de résultats Y2 comportant au moins un deuxième résultat y2, le deuxième ensemble de résultats Y2 étant généré par application d'un deuxième traitement par l'unité de traitement 4 à partir du au moins un paramètre x de l'ensemble de paramètres X mémorisé dans la seconde zone 7 de l'unité de stockage 5. En outre, le premier traitement et le deuxième traitement sont également configurés pour obtenir le premier ensemble de résultats Y1 égal au deuxième ensemble de résultats Y2.

Cette étape de génération 24 d'au moins une seconde image peut comporter quant à elle une seconde sous étape de duplication 25 de l'ensemble de paramètres X dans la mémoire cache 8 de l'unité de traitement 4.

Le procédé 10 comporte alors une étape de mémorisation 126 du deuxième ensemble de résultats Y2 dans une seconde zone de la seconde unité de stockage.

Le procédé 10 comporte alors ensuite une séquence S1 consistant à répéter plusieurs fois en boucle un premier affichage 16 de la au moins une première image sur l'écran d'affichage 3 pendant une première période de temps prédéterminée puis une étape de second affichage 26 de la au moins une seconde image sur l'écran d'affichage 3 pendant une seconde période de temps prédéterminée.

A l'issue de cette période de temps prédéterminée, la ou les images générées à l'étape de génération 14 est alors substituée à la ou aux images générées à l'étape de génération 24.

Selon ce premier exemple de procédé 10, l'alternance d'affichage des première et seconde images est donc réalisée en mémorisant et en affichant successivement les résultats obtenus aux étapes de génération d'images 14 et 24 sans refaire les étapes précédentes.

Alternativement selon un second exemple de procédé 10 représenté à la figure 3, le procédé peut comporter une étape de second effacement 27 d'étapes de calcul opérées lors du second traitement, les étapes de calcul étant effacées de la mémoire cache 8 de l'unité de traitement 4.

Eventuellement, tout ou partie des paramètres de x et des résultats intermédiaires peuvent être effacés de la mémoire cache 8 de l'unité de traitement 4. Dans ce cas, les calculs peuvent être repris à l'étape de génération 14 d'au moins une première image.

Le procédé 10 comporte alors une autre séquence S2 consistant à répéter plusieurs fois en boucle la génération 14 d'au moins une première image, le premier affichage 16 de la au moins une première image, le premier effacement 17 de premiers résultats intermédiaires, la génération 24 d'au moins une seconde image, le second affichage 26 de la au moins une seconde image et le second effacement 27 d'étapes de calcul.

Comme précédemment, l'image générée à l'étape de génération 24 est alors substituée à l'image générée à l'étape de génération 14.

En pratique, chaque première étape d'effacement 17 et chaque seconde étape d'effacement 27 opérées lors de la séquence S2 peuvent être réalisées respectivement au moyen d'une pluralité de calculs générant une pluralité de résultats stockés dans la mémoire cache 8 de l'unité de traitement 4 pour remplacer l'ensemble de paramètres X et éventuellement des résultats intermédiaires

Ce procédé 10 de test permet alors à un utilisateur du dispositif électroportatif 1 de détecter une perte d'intégrité du dispositif électroportatif 1 préalablement à son utilisation ou bien encore lors de son utilisation lors d'une phase de vol de l'aéronef.

Par exemple, le premier traitement et le deuxième traitement peuvent être identiques ou encore être différents mais équivalents c'est à dire que le premier traitement et le deuxième traitement sont configurés pour obtenir le premier ensemble de résultats Y1 et le deuxième ensemble de résultats Y2 égaux entre eux. Dans ce second cas, le premier traitement peut alors mettre en oeuvre des calculs opérés selon un premier ordre et le deuxième traitement peut mettre en oeuvre des calculs équivalents opérés selon un second ordre différent du premier ordre.

Par conséquent, sauf en cas de perte d'intégrité du dispositif électroportatif 1, les premier et deuxième ensembles de résultats Y1 et Y2 sont égaux et par suite les premières et secondes images doivent être identiques entre elles.

Dès lors, la détection d'une perte d'intégrité du dispositif électroportatif 1 peut par exemple être opérée visuellement par l'utilisateur s'il constate des différences entre les premières images et les secondes images correspondantes. De telles différences peuvent alors avoir pour effet de générer un affichage clignotant des images sur l'écran d'affichage 3. Un tel clignotement des images est alors aisément perceptible par un pilote ou tout membre d'équipage de l'aéronef.

En outre, une telle détection d'une perte d'intégrité du dispositif électroportatif 1 peut également être partiellement réalisée automatiquement par une analyse des différences entre les premières images et les secondes images. Une telle analyse peut avantageusement être réalisée directement par l'unité de traitement 4 du dispositif électroportatif 1.

Par exemple, la au moins une première image peut comporter un premier fond agencé en arrière plan et le premier ensemble de résultats Y1 affiché en superposition sur le premier fond. De même, la au moins une seconde image peut comporter un second fond agencé en arrière plan et le deuxième ensemble de résultats Y2 affiché en superposition sur le second fond.

Par ailleurs, lorsque ce premier fond est affiché pendant la première période de temps prédéterminée, le premier ensemble de résultats Y1 peut quant à lui être affiché avec un premier retard pendant une première durée inférieure à la première période de temps prédéterminée.

Ce premier retard permet alors, notamment lors du passage d'un écran de saisie à un écran de résultats comportant la au moins une première image et réciproquement lors du passage de l'écran de résultat à l'écran de saisie, de réaliser un affichage dynamique du premier ensemble de résultats Y1. Un tel affichage dynamique des au moins une première image permet ainsi à l'utilisateur de détecter visuellement un gel de l'écran d'affichage 3 du dispositif électroportatif 1.

Tel que représenté à la figure 3, préalablement à la séquence S2, un deuxième exemple de réalisation d'un procédé 10 de test d'un dispositif électroportatif 1 peut comporter une succession de plusieurs étapes supplémentaires opérées par exemple en parallèle des étapes d'acquisition 11, 11' de l'ensemble de paramètres X, de mémorisation 12' de l'ensemble de paramètres X dans la première zone 6 et de mémorisation 13' de l'ensemble de paramètres X dans la seconde zone 7.

Ainsi, une telle succession d'étapes supplémentaires peut comporter une étape de génération 41, 41' d'un troisième et quatrième ensemble de résultats Y3 et Y4 par application d'un troisième et quatrième traitement par l'unité de traitement 4 à partir d'au moins un paramètre de test x3 et un autre paramètre de test x4. En outre, de tels troisième et quatrième traitements sont différents du premier traitement et du deuxième traitement.

Cette succession d'étapes supplémentaires comporte alors ensuite une étape de comparaison 42, 42' du troisième et quatrième ensemble de résultats Y3 et Y4 avec des ensembles de résultats attendus Z3 et Z4 mémorisés par exemple dans la première unité de stockage 5.

Enfin, une étape de détection 43, 43' d'une perte d'intégrité du dispositif électroportatif 1 peut être mise en oeuvre lorsque la différence entre le troisième ou quatrième résultat y3, y4 et le résultat attendu de l'étape est différente de zéro.

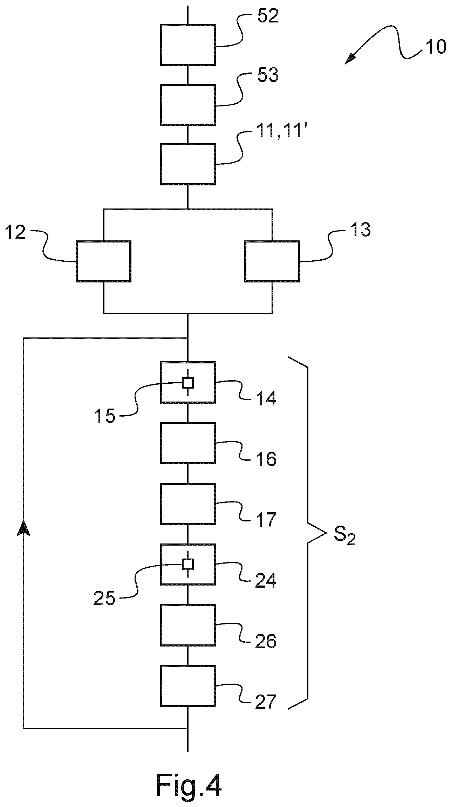

De manière compatible avec les autres variantes, tel que représenté à la figure 4, un troisième exemple de réalisation d'un procédé 10 de test d'un dispositif électroportatif 1 peut comporter d'autres étapes supplémentaires ajoutées aux étapes du premier exemple de réalisation du procédé 10 de test illustré à la figure 2. Ces autres étapes supplémentaires comportent ainsi une étape d'affichage 52 d'au moins une image de référence mémorisée dans la première unité de stockage 5, cette image de référence permettant d'activer tous les pixels constituant l'écran d'affichage 3.

Ces autres étapes supplémentaires comportent alors également une étape de détection 53 d'un défaut d'affichage d'au moins un pixel de l'écran d'affichage 3.

Telles que représentées, une telle étape d'affichage 52 de la au moins une image de référence et une telle étape de détection 53 d'un défaut d'affichage peuvent avantageusement être opérées préalablement à l'étape d'acquisition 11, 11' d'au moins un paramètre x de l'ensemble de paramètres X.

Par ailleurs, l'étape d'affichage 52 de la au moins une image de référence et l'étape de détection 53 d'un défaut d'affichage peuvent par exemple être opérées en fournissant, via l'organe d'acquisition 2, un ordre de commande à l'unité de traitement 4.

Naturellement, la présente invention est sujette à de nombreuses variations quant à sa mise en œuvre.

L'invention est définie par le jeu de revendications annexé.

## Revendications

1. Procédé (10) de test d'un dispositif électroportatif (1), ledit dispositif électroportatif (1) comportant un organe d'acquisition (2), une unité de traitement (4) comportant une mémoire cache (8), une première unité de stockage (5) et un écran d'affichage (3), **caractérisé en ce que** ledit procédé (10) comporte les étapes suivantes :

   • acquisition (11, 11') d'un ensemble de paramètres (X) comportant au moins un paramètre (x) via ledit organe d'acquisition (2),
   • mémorisation (12, 12') dudit ensemble de paramètre (X) dans une première zone (6) de ladite première unité de stockage (5),
   • mémorisation (13, 13') dudit ensemble de paramètres (X) dans une seconde zone (7) de ladite première unité de stockage (5), ladite seconde zone (7) étant distincte de ladite première zone (6),
   • génération (14) d'au moins une première image représentative d'un premier ensemble de résultats (Y1) comportant au moins un premier résultat (y1), ledit premier ensemble de résultats (Y1) étant généré par application d'un premier traitement par ladite unité de traitement (4) à partir dudit ensemble de paramètres (X) mémorisé dans ladite première zone (6) de ladite première unité de stockage (5),
   • premier affichage (16) de ladite au moins une première image sur ledit écran d'affichage (3) pendant une première période de temps prédéterminée,
   • premier effacement (17) de premiers résultats intermédiaires correspondant à des étapes de calcul opérées lors dudit premier traitement, lesdits premiers résultats intermédiaires étant effacés de ladite mémoire cache (8) de ladite unité de traitement (4),
   • génération (24) d'au moins une seconde image représentative d'un deuxième ensemble de résultats (Y2) comportant au moins un deuxième résultat y2, ledit deuxième ensemble de résultats (Y2) étant généré par application d'un deuxième traitement par ladite unité de traitement (4) à partir dudit ensemble de paramètres (X) mémorisé dans ladite seconde zone (7) de ladite première unité de stockage (5), ledit premier ensemble de résultats (Y1) et ledit deuxième ensemble de résultats (Y2) étant égaux sauf en cas de perte d'intégrité dudit dispositif électroportatif (1) et
   • second affichage (26) de ladite au moins une seconde image sur ledit écran d'affichage (3) pendant une seconde période de temps prédéterminée.

2. Procédé selon la revendication 1, **caractérisé en ce que** ledit procédé (10) comporte une mémorisation (116) dudit premier ensemble de résultats (Y1) dans une première zone d'une seconde unité de stockage et une mémorisation (126) dudit deuxième ensemble de résultats (Y2) dans une seconde zone de ladite seconde unité de stockage.

3. Procédé selon la revendication 1, **caractérisé en ce que** ledit procédé (10) comporte un second effacement (27) d'étapes de calcul opérées lors dudit second traitement, lesdites étapes de calcul étant effacées de ladite mémoire cache (8) de ladite unité de traitement (4).

4. Procédé selon l'une quelconque des revendications 1 à 3, **caractérisé en ce que** ledit premier traitement et ledit deuxième traitement sont identiques.

**5.** Procédé selon l'une quelconque des revendications 1 à 3, **caractérisé en ce que** ledit premier traitement et ledit deuxième traitement sont équivalents, ledit premier traitement mettant en oeuvre des calculs opérés selon un premier ordre et ledit deuxième traitement mettant en oeuvre des calculs équivalents opérés selon un second ordre différent dudit premier ordre.

**6.** Procédé selon l'une quelconque des revendications 1 à 5, **caractérisé en ce que** ladite au moins une première image comporte un premier fond agencé en arrière plan et ledit premier ensemble de résultats (Y1) rapporté en superposition sur ledit premier fond et ladite au moins une seconde image comporte un second fond agencé en arrière plan et ledit deuxième ensemble de résultats (Y2) rapporté en superposition sur ledit second fond.

**7.** Procédé selon l'une quelconque des revendications 1 à 6, **caractérisé en ce que** ladite première période de temps prédéterminée est égale à ladite seconde période de temps prédéterminée.

**8.** Procédé selon l'une quelconque des revendications 1 à 7, **caractérisé en ce que** ledit procédé (10) comporte les étapes suivantes :

• génération (41) d'un troisième ensemble de résultats (Y3) comportant au moins un troisième résultat (y3) par application d'un troisième traitement par ladite unité de traitement (4) à partir d'un ensemble test de paramètres (X3) comportant au moins un paramètre de test (x3) préalablement mémorisé,
• comparaison (42) dudit troisième ensemble de résultats (Y3) avec un ensemble de résultats attendus (Z3) préalablement mémorisé,
• détection (43) d'une perte d'intégrité dudit dispositif électroportatif (1) lorsqu'une différence entre ledit troisième ensemble de résultats (Y3) et ledit ensemble de résultats attendus (Z3) est différente de zéro.

**9.** Procédé selon l'une quelconque des revendications 1 à 8, **caractérisé en ce que** ledit procédé (10) comporte les étapes suivantes :

• génération (41') d'un quatrième ensemble de résultats (Y4) comportant au moins un quatrième résultat (y4) par application d'un quatrième traitement par ladite unité de traitement (4) à partir d'un autre ensemble de test (X4) comportant au moins un autre paramètre de test (x4) généré de manière aléatoire, ledit quatrième traitement étant différent dudit premier traitement et dudit deuxième traitement,
• comparaison (42') dudit quatrième ensemble de résultats (Y4) avec un autre ensemble de résultats attendus (Z4) mémorisé,
• détection (43') d'une perte d'intégrité dudit dispositif électroportatif (1) lorsqu'une différence entre ledit quatrième ensemble de résultats (Y4) et ledit autre ensemble de résultats attendus (Z4) est différente de zéro.

**10.** Procédé selon l'une quelconque des revendications 1 à 9, **caractérisé en ce que**, ledit procédé (10) comporte les étapes suivantes :

• affichage (52) d'au moins une image de référence mémorisée, ladite au moins une image de référence permettant d'activer tous les pixels constituant ledit écran d'affichage (3),
• détection (53) d'un défaut d'affichage d'au moins un pixel dudit écran d'affichage (3).

**11.** Procédé selon la revendication 10, **caractérisé en ce que** ladite étape d'affichage (52) de ladite au moins une image de référence et ladite étape de détection (53) d'un défaut d'affichage sont opérées préalablement à ladite étape d'acquisition (11, 11') dudit ensemble de paramètres (X).

**12.** Procédé selon l'une quelconque des revendications 10 à 11, caractérisé en ce ledit procédé (10) comporte une étape de transmission (54) d'un ordre de commande dudit organe d'acquisition (2) vers ladite unité de traitement (4), ledit ordre de commande étant porteur d'un appel de ladite étape d'affichage (52) de ladite au moins une image de référence.

**13.** Procédé selon la revendication l'une quelconque des revendications 1 à 12, **caractérisé en ce que** ladite étape d'acquisition (11) comporte une saisie dudit ensemble de paramètres (X) avec un dispositif de saisie manuelle (9) dudit organe d'acquisition (2), ledit dispositif de saisie manuelle (9) étant choisi parmi le groupe comportant, les boutons de commande, les claviers, les désignateurs, les souris, les molettes et les dalles tactiles.

**14.** Procédé selon la revendication l'une quelconque des revendications 1 à 13, **caractérisé en ce que** ladite étape d'acquisition (11') comporte une réception d'un signal électromagnétique porteur dudit ensemble de paramètres (X), ledit organe d'acquisition (2) comportant une carte de communication sans fil (19) apte à recevoir ledit signal électromagnétique par un protocole de communication sans fil.

15. Procédé selon la revendication l'une quelconque des revendications 1 à 14, **caractérisé en ce que** ladite première étape d'effacement comporte une pluralité de calculs générant une pluralité de résultats stockés dans ladite mémoire cache (8) de ladite unité de traitement (4) pour forcer un remplacement desdits résultats intermédiaires de ladite mémoire cache (8) de ladite unité de traitement (4).


**Patentansprüche**

1. Verfahren (10) zum Testen eines tragbaren elektronischen Geräts (1), wobei das tragbare elektronische Gerät (1) ein Erfassungsorgan (2), eine Verarbeitungseinheit (4) mit einem Cache-Speicher (8), eine erste Speichereinheit (5) und einen Anzeigeschirm (3) umfasst, **dadurch gekennzeichnet, dass** das Verfahren (10) die folgenden Schritte umfasst:

   - Erfassen (11, 11') eines Satzes von Parametern (X), der mindestens einen Parameter (x) enthält, über das Erfassungsorgan (2),
   - Speichern (12, 12') des Satzes von Parametern (X) in einem ersten Bereich (6) der ersten Speichereinheit (5),
   - Speichern (13, 13') des Parametersatzes (X) in einem zweiten Bereich (7) der ersten Speichereinheit (5), wobei der zweite Bereich (7) von dem ersten Bereich (6) verschieden ist,
   - Erzeugen (14) mindestens eines ersten Bildes, das repräsentativ für einen ersten Satz von Ergebnissen (Y1) ist, der mindestens ein erstes Ergebnis (y1) enthält, wobei der erste Satz von Ergebnissen (Y1) durch Anwendung einer ersten Verarbeitung durch die Verarbeitungseinheit (4) ausgehend von dem in dem ersten Bereich (6) der ersten Speichereinheit (5) gespeicherten Satz von Parametern (X) erzeugt wird,
   - erstes Anzeigen (16) des mindestens einen ersten Bildes auf dem Anzeigeschirm (3) für eine erste vorgegebene Zeitspanne,
   - erstes Löschen (17) von ersten Zwischenergebnissen, die bei der ersten Verarbeitung durchgeführten Rechenschritten entsprechen, wobei die ersten Zwischenergebnisse aus dem Cache-Speicher (8) der Verarbeitungseinheit (4) gelöscht werden,
   - Erzeugen (24) mindestens eines zweiten Bildes, das repräsentativ für einen zweiten Satz von Ergebnissen (Y2) ist, der mindestens ein zweites Ergebnis y2 enthält, wobei der zweite Satz von Ergebnissen (Y2) durch Anwendung einer zweiten Verarbeitung durch die Verarbeitungseinheit (4) ausgehend von dem in dem zweiten Bereich (7) der ersten Speichereinheit (5) gespeicherten Satz von Parametern (X) erzeugt wird, wobei der erste Satz von Ergebnissen (Y1) und der zweite Satz von Ergebnissen (Y2) gleich sind, außer im Fall eines Integritätsverlusts des tragbaren elektronischen Geräts (1), und
   - zweites Anzeigen (26) des mindestens einen zweiten Bildes auf dem Anzeigebildschirm (3) für eine zweite vorgegebene Zeitspanne.

2. Verfahren nach Anspruch 1, **dadurch gekennzeichnet, dass** das Verfahren (10) ein Speichern (116) des ersten Satzes von Ergebnissen (Y1) in einem ersten Bereich einer zweiten Speichereinheit und ein Speichern (126) des zweiten Satzes von Ergebnissen (Y2) in einem zweiten Bereich der zweiten Speichereinheit umfasst.

3. Verfahren nach Anspruch 1, **dadurch gekennzeichnet, dass** das Verfahren (10) ein zweites Löschen (27) von bei der zweiten Verarbeitung durchgeführten Rechenschritten umfasst, wobei die Rechenschritte aus dem Cache-Speicher (8) der Verarbeitungseinheit (4) gelöscht werden.

4. Verfahren nach einem der Ansprüche 1 bis 3, **dadurch gekennzeichnet, dass** die erste Verarbeitung und die zweite Verarbeitung identisch sind.

5. Verfahren nach einem der Ansprüche 1 bis 3, **dadurch gekennzeichnet, dass** die erste Verarbeitung und die zweite Verarbeitung äquivalent sind, wobei die erste Verarbeitung Berechnungen implementiert, die in einer ersten Reihenfolge durchgeführt werden, und die zweite Verarbeitung äquivalente Berechnungen implementiert, die in einer zweiten Reihenfolge durchgeführt werden, die sich von der ersten Reihenfolge unterscheidet.

6. Verfahren nach einem der Ansprüche 1 bis 5, **dadurch gekennzeichnet, dass** das mindestens eine erste Bild einen ersten Bildhintergrund, der im Hintergrund angeordnet ist, und den ersten Satz von Ergebnissen (Y1), der dem ersten Bildhintergrund überlagert ist, aufweist, und das mindestens eine zweite Bild einen zweiten Bildhintergrund, der im Hintergrund angeordnet ist, und den zweiten Satz von Ergebnissen (Y2), der dem zweiten Bildhintergrund überlagert ist, aufweist.

7. Verfahren nach einem der Ansprüche 1 bis 6, **dadurch gekennzeichnet, dass** die erste vorgegebene Zeitspanne gleich der zweiten vorgegebenen Zeitspanne ist.

**8.** Verfahren nach einem der Ansprüche 1 bis 7, **dadurch gekennzeichnet, dass** das Verfahren (10) die folgenden Schritte umfasst:

- Erzeugen (41) eines dritten Satzes von Ergebnissen (Y3) mit mindestens einem dritten Ergebnis (y3) durch Anwenden einer dritten Verarbeitung durch die Verarbeitungseinheit (4) auf einen Testsatz von Parametern (X3), der mindestens einen zuvor gespeicherten Testparameter (x3) enthält,
- Vergleichen (42) des dritten Satzes von Ergebnissen (Y3) mit einem zuvor gespeicherten Satz von erwarteten Ergebnissen (Z3),
- Erkennen (43) eines Integritätsverlusts des tragbaren elektronischen Geräts (1), wenn eine Differenz zwischen dem dritten Satz von Ergebnissen (Y3) und dem Satz von erwarteten Ergebnissen (Z3) von Null verschieden ist.

**9.** Verfahren nach einem der Ansprüche 1 bis 8, **dadurch gekennzeichnet, dass** das Verfahren (10) die folgenden Schritte umfasst:

- Erzeugen (41') eines vierten Satzes von Ergebnissen (Y4) mit mindestens einem vierten Ergebnis (y4) durch Anwenden einer vierten Verarbeitung durch die Verarbeitungseinheit (4) auf einen weiteren Testsatz (X4), der mindestens einen weiteren zufällig erzeugten Testparameter (x4) enthält, wobei sich die vierte Verarbeitung von der ersten Verarbeitung und der zweiten Verarbeitung unterscheidet,
- Vergleichen (42') des vierten Satzes von Ergebnissen (Y4) mit einem anderen gespeicherten Satz von erwarteten Ergebnissen (Z4),
- Erkennen (43') eines Integritätsverlusts des tragbaren elektronischen Geräts (1), wenn eine Differenz zwischen dem vierten Satz von Ergebnissen (Y4) und dem anderen Satz von erwarteten Ergebnissen (Z4) von Null verschieden ist.

**10.** Verfahren nach einem der Ansprüche 1 bis 9, **dadurch gekennzeichnet, dass** das Verfahren (10) die folgenden Schritte umfasst:

- Anzeigen (52) mindestens eines gespeicherten Referenzbildes, wobei das mindestens eine Referenzbild die Aktivierung aller Pixel ermöglicht, die den Anzeigeschirm (3) bilden,
- Erkennen (53) eines Anzeigefehlers von mindestens einem Pixel des Anzeigeschirms (3).

**11.** Verfahren nach Anspruch 10, **dadurch gekennzeichnet, dass** der Schritt des Anzeigens (52) des mindestens einen Referenzbildes und der Schritt des Erkennens (53) eines Anzeigefehlers vor dem Schritt des Erfassens (11, 11') des Satzes von Parametern (X) durchgeführt werden.

**12.** Verfahren nach einem der Ansprüche 10 bis 11, **dadurch gekennzeichnet, dass** das Verfahren (10) einen Schritt des Übertragens (54) eines Steuerbefehls von dem Erfassungsorgan (2) an die Verarbeitungseinheit (4) umfasst, wobei der Steuerbefehl einen Aufruf des Schritts des Anzeigens (52) des mindestens einen Referenzbildes beinhaltet.

**13.** Verfahren nach einem der Ansprüche 1 bis 12, **dadurch gekennzeichnet, dass** der Schritt des Erfassens (11) ein Eingeben des Satzes von Parametern (X) mit einer manuellen Eingabevorrichtung (9) des Erfassungsorgans (2) umfasst, wobei die manuelle Eingabevorrichtung (9) aus der Gruppe ausgewählt ist, die aus Steuerknöpfen, Tastaturen, Zeigeinstrumenten, Mäusen, Scrollrädern und berührungsempfindlichen Platten besteht.

**14.** Verfahren nach einem der Ansprüche 1 bis 13, **dadurch gekennzeichnet, dass** der Schritt des Erfassens (11') ein Empfangen eines elektromagnetischen Signals umfasst, das den Satz von Parametern (X) beinhaltet, wobei das Erfassungsorgan (2) eine Drahtloskommunikationskarte (19) umfasst, die eingerichtet ist, das elektromagnetische Signal über ein Drahtloskommunikationsprotokoll zu empfangen.

**15.** Verfahren nach einem der Ansprüche 1 bis 14, **dadurch gekennzeichnet, dass** der erste Schritt des Löschens eine Mehrzahl von Berechnungen umfasst, die eine Mehrzahl von Ergebnissen liefern, die in dem Cache-Speicher (8) der Verarbeitungseinheit (4) gespeichert werden, um ein Ersetzen der Zwischenergebnisse aus dem Cache-Speicher (8) der Verarbeitungseinheit (4) zu erzwingen.

**Claims**

**1.** A method (10) for testing a portable electronic device (1), said portable electronic device (1) including an acquisition member (2), a processing unit (4) including a cache memory (8), a first storage unit (5), and a display screen (3),
**characterized in that** said method (10) comprises the following steps:

• acquiring (11, 11') a set of parameters (X) including at least one parameter (x) via said acquisition member (2);
• storing (12, 12') said set of parameters (X) in a first area (6) of said first storage unit (5);
• storing (13, 13') said set of parameters (X) in a second area (7) of said first storage unit (5), said second area (7) being separate from said first area (6);

• generating (14) at least one first image representative of a first set of results (Y1) including at least one first result (y1), said first set of results (Y1) being generated by the application, by said processing unit (4), of a first processing operation based on said set of parameters (X) stored in said first area (6) of said first storage unit (5);

• in a first displaying step (16), displaying said at least one first image on said display screen (3) for a first predetermined time period;

• in a first erasing step (17), erasing first intermediate results corresponding to calculation steps carried out during said first processing operation, said first intermediate results being erased from said cache memory (8) of said processing unit (4);

• generating (24) at least one second image representative of a second set of results (Y2) including at least one second result (y2), said second set of results (Y2) being generated by the application, by said processing unit (4), of a second processing operation based on said set of parameters (X) stored in said second area (7) of said first storage unit (5), said first set of results (Y1) and said second set of results (Y2) being equal except in the event of loss of integrity of said portable electronic device (1); and

• in a second displaying step (26), displaying said at least one second image on said display screen (3) for a second predetermined time period.

2. A method according to claim 1, **characterized in that** said method (10) comprises storing (116) said first set of results (Y1) in a first area of a second storage unit and storing (126) said second set of results (Y2) in a second area of said second storage unit.

3. A method according to claim 1, **characterized in that** said method (10) includes a second erasing step (27) for erasing calculation steps carried out during said second processing operation, said calculation steps being erased from said cache memory (8) of said processing unit (4).

4. A method according to any one of claims 1 to 3, **characterized in that** said first processing operation and said second processing operation are identical.

5. A method according to any one of claims 1 to 3, **characterized in that** said first processing operation and said second processing operation are equivalents, said first processing operation implementing calculations carried out in a first order and said second processing operation implementing equivalent calculations carried out in a second order different from said first order.

6. A method according to any one of claims 1 to 5, **characterized in that** said at least one first image includes a first background arranged as a backdrop and said first set of results (Y1) overlaid on said first background, and said at least one second image includes a second background arranged as a backdrop and said second set of results (Y2) overlaid on said second background.

7. A method according to any one of claims 1 to 6, **characterized in that** said first predetermined time period is equal to said second predetermined time period.

8. A method according to any one of claims 1 to 7, **characterized in that** said method (10) comprises the following steps:

• generating (41) a third set of results (Y3) comprising at least one third result (y3) by application, by said processing unit (4), of a third processing operation based on a test set of parameters (X3) comprising at least one previously stored test parameter (x3);

• comparing (42) said third set of results (Y3) with a previously stored set of expected results (Z3); and

• detecting (43) a loss of integrity of said portable electronic device (1) when a difference between said third set of results (Y3) and said set of expected results (Z3) is different from zero.

9. A method according to any one of claims 1 to 8, **characterized in that** said method (10) comprises the following steps:

• generating (41') a fourth set of results (Y4) comprising at least one fourth result (y4) by application, by said processing unit (4), of a fourth processing operation based on another test set (X4) comprising at least one other randomly generated test parameter (x4), said fourth processing operation being different from said first processing operation and said second processing operation;

• comparing (42') said fourth set of results (Y4) with another stored set of expected results (Z4); and

• detecting (43') a loss of integrity of said portable electronic device (1) when a difference between said fourth set of results (Y4) and said other set of expected results (Z4) is different from zero.

10. A method according to any one of claims 1 to 9, **characterized in that** said method (10) comprises the following steps:

• displaying (52) at least one stored reference image, said at least one reference image allowing all the pixels constituting the display screen (3) to be activated; and

• detecting (53) a display defect in at least one pixel of said display screen (3).

11. A method according to claim 10, **characterized in that** said step (52) of displaying said at least one reference image and said step (53) of detecting a display defect are performed prior to said step (11, 11') of acquiring said set of parameters (X).

12. A method according to any one of claims 10 to 11, **characterized in that** said method (10) includes a step (54) of transmitting a control order from said acquisition member (2) to said processing unit (4), said control order carrying a request for said step (52) of displaying said at least one reference image.

13. A method according to any one of claims 1 to 12, **characterized in that** said acquisition step (11) includes inputting said set of parameters (X) with a manual input device (9) of said acquisition member (2), said manual input device (9) being selected from the group comprising control buttons, keyboards, designators, mice, thumbwheels and touch panels.

14. A method according to any one of claims 1 to 13, **characterized in that** said acquisition step (11') comprises receiving an electromagnetic signal carrying said set of parameters (X), said acquisition member (2) comprising a wireless communication card (19) capable of receiving said electromagnetic signal via a wireless communication protocol.

15. A method according to any one of claims 1 to 14, **characterized in that** said first erasing step comprises a plurality of calculations generating a plurality of results stored in said cache memory (8) of said processing unit (4) in order to force the replacement of said intermediate results of said cache memory (8) of said processing unit (4).

Fig.1

Fig.2

Fig.3

Fig.4

**EP 4 057 271 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3495775 A
- US 2019196926 A1
- US 2018329780 A1
- US 20070233765 A1
- US 2009243893 A1